# FASCICULE DE BREVET EUROPEEN

(11) **EP 1 626 437 B1**
(45) Date de publication et mention de la délivrance du brevet: **07.07.2010**
(21) Numéro de dépôt: 05107422.7
(22) Date de dépôt: 12.08.2005
(51) Int. Cl.: H01L 21/20, H01L 29/12

(54) **Procédé de réalisation d'empilements d'îlots de matériau semi-conducteur encapsulés dans un autre matériau semi-conducteur**
Verfahren zur Herstellung von gestapelten Inselstrukturen aus einem Halbleitermaterial in einem anderen Halbleitermaterial
Method of fabricating a stack of islands made of a semiconductor material in another semiconductor material

(30) Priorité: 13.08.2004 FR 0451850
(43) Date de publication de la demande: 15.02.2006
(73) Titulaire: Commissariat à l'Énergie Atomique et aux Énergies Alternatives, 75015 Paris (FR)
(72) Inventeur: Damlencourt, Jean-François, 38120 Saint-Egrève (FR); Vandelle, Benoît, 38240, Meylan (FR)
(74) Mandataire: Poulin, Gérard

(56) Documents cités:
- US-A- 5 354 707
- US-A- 5 888 885
- US-B2- 6 596 555
- ABSTREITER G ET AL: "GROWTH AND CHARACTERIZATION OF SELF-ASSEMBLED GE-RICH ISLANDS ON SI" SEMICONDUCTOR SCIENCE AND TECHNOLOGY, INSTITUTE OF PHYSICS. LONDON, GB, vol. 11, no. 11S, 1 novembre 1996 (1996-11-01), pages 1521-1528, XP000630334 ISSN: 0268-1242
- LE THANH VINH ET AL: "Vertical ordering in multilayers of self-assembled Ge/Si(001) quantum dots" JOURNAL OF VACUUM SCIENCE AND TECHNOLOGY. B, MICROELECTRONICS AND NANOMETER STRUCTURES PROCESSING, MEASUREMENT AND PHENOMENA, AMERICAN INSTITUTE OF PHYSICS, NEW YORK, NY, US, vol. 20, no. 3, mai 2002 (2002-05), pages 1259-1265, XP012009339 ISSN: 1071-1023
- EAGLESHAM D J ET AL: "DISLOCATION-FREE STRANSKI-KRASTANOW GROWTH OF GE ON SI(100)" PHYSICAL REVIEW LETTERS, AMERICAN PHYSICAL SOCIETY, NEW YORK, US, vol. 64, no. 16, 16 avril 1990 (1990-04-16), pages 1943-1946, XP000205995 ISSN: 0031-9007
- FERRANDIS P ET AL: "Growth and characterization of Ge islands on Si(110)" MATERIALS SCIENCE AND ENGINEERING B, ELSEVIER SEQUOIA, LAUSANNE, CH, vol. 89, no. 1-3, 14 février 2002 (2002-02-14), pages 171-175, XP004334391 ISSN: 0921-5107
- YAM V ET AL: "Kinetics of the heteroepitaxial growth of Ge on Si(001)" JOURNAL OF VACUUM SCIENCE AND TECHNOLOGY. B, MICROELECTRONICS AND NANOMETER STRUCTURES PROCESSING, MEASUREMENT AND PHENOMENA, AMERICAN INSTITUTE OF PHYSICS, NEW YORK, NY, US, vol. 20, no. 3, mai 2002 (2002-05), pages 1251-1258, XP012009338 ISSN: 1071-1023

## Description

### DOMAINE TECHNIQUE

L'invention se rapporte à un procédé de réalisation d'empilements d'îlots de matériau semiconducteur encapsulés dans un autre matériau semiconducteur. Elle se rapporte en particulier à la réalisation d'empilements d'îlots de germanium encapsulés dans du silicium.

Les circuits intégrés réalisés avec la technologie microélectronique basée sur le silicium sont de plus en plus complexes et rapides. Les dispositifs et groupes fonctionnels de ces circuits intégrés sont aujourd'hui reliés par des lignes métalliques. Ces dernières présentent des limitations, en particulier une constante de temps RC et une forte dissipation thermique qui, malgré les évolutions technologiques, ne pourront pas permettre de poursuivre l'augmentation des fréquences de fonctionnement des microprocesseurs. L'idée d'utiliser les liens optiques comme alternative aux interconnexions métalliques émerge. Par rapport aux lignes métalliques, les liens optiques offrent : un gain en rapidité, une réduction de l'altération du signal, une propagation sans dissipation thermique et la possibilité de multiplexage en longueur d'onde. Les liens (fibres) optiques étant déjà utilisés dans les réseaux à plus ou moins grande échelle (des réseaux locaux aux réseaux internationaux), le concept de connexions « tout optique » des transistors aux réseaux se dessine.

La réalisation d'interconnexions optiques au sein des circuits intégrés requiert la fabrication de dispositifs optoélectroniques, plus précisément des sources de lumière, des modulateurs de signaux (pour générer le signal haute fréquence) et des photo-détecteurs ultra-rapides. Une conception des circuits intégrés de type monolithique étant favorable d'un point de vue technologique, un grand intérêt est porté depuis une dizaine d'années sur la réalisation de dispositifs optoélectroniques avec une technologie compatible avec la microélectronique sur silicium. Les matériaux III-V, classiquement mis en oeuvre dans ce genre d'applications, sont alors exclus, et le germanium, dont la largeur de bande interdite est plus faible que celle du silicium, est le candidat le plus prometteur. De plus, le germanium présente l'avantage d'être déjà mis en oeuvre dans l'industrie microélectronique.

### ÉTAT DE LA TECHNIQUE ANTÉRIEURE

Pour son utilisation en photo-détection, le germanium est déposé par épitaxie soit sous forme de couches « épaisses » (plusieurs centaines de nanomètres), soit sous forme d'un alliage avec du silicium pour réaliser des multi-puits quantiques (empilements de couches de silicium et d'alliage silicium-germanium). Ces deux types de structures constituent la zone d'absorption des photons incidents dans les photo-détecteurs. Cependant, les propriétés optiques des couches épaisses de germanium pur sont dégradées par la présence de dislocations (dues au désaccord de maille avec le substrat de silicium) et des difficultés d'intégration dans les dispositifs sont rencontrées (rugosité des couches élevée, prise de contact problématique...). Quant aux multi-puits quantiques de couches de silicium et d'alliages silicium-germanium, ils présentent un coefficient d'absorption qui est trop faible pour une photo-détection efficace.

La croissance du germanium sur du silicium selon le mode Stranski-Krastanov est une alternative aux deux méthodes décrites ci-dessus. Un exemple de formation de photodétecteur constitué d'îlots de germanium est donné par El Kurdi et al. dans Physica E 16, 523 (2003). Le mode de croissance Stranski-Krastanov permet de former des îlots de germanium de petite taille, avec une distribution relativement homogène de cette taille. Deux types d'îlots sont généralement formés : des pyramides et des dômes de petite taille. Le prolongement du dépôt conduit à la formation de dômes de grande taille qui sont plastiquement relaxés, c'est-à-dire que ces dômes contiennent des dislocations. Les dômes de petite taille, dans lesquels les contraintes sont relâchées de façon élastique, sont les structures recherchées.

Des empilements de couches d'îlots de germanium peuvent être réalisés en séparant les couches d'îlots par des couches de silicium, de façon analogue aux multi-puits quantiques. Ces empilements permettent d'absorber plus efficacement les photons incidents que les multi-puits quantiques à base de couches d'alliage silicium-germanium, tout en posant moins de difficultés d'intégration que le germanium pur. Cependant, les propriétés optiques des couches d'îlots de germanium sont sensibles aux caractéristiques des îlots, principalement leur taille, la distribution de leur taille, leur densité surfacique, et leur composition.

Les différentes études menées jusqu'à présent montrent que des plans d'îlots de forte densité surfacique et de faible taille donnent de meilleurs résultats en terme de qualité et rendement optique. Cependant, pour obtenir ces caractéristiques, il faut soit travailler à faible température (T < 650°C) et/ou à forte pression partielle de Germane (P > 0.11 Pa (0,83 mTorr)). Or, les îlots élaborés à faible température ont des propriétés optiques dégradées. Dans le cas où les îlots sont élaborés à forte pression de germane et à la température optimale de croissance, le problème du contrôle de la quantité de matière déposée est critique et ce à partir du deuxième plan de l'empilement. En effet, l'augmentation de la pression partielle de germane conduit à une augmentation de la vitesse de croissance, si bien que les temps de dépôts sont réduits à quelques secondes. Dès lors, une dérive, même très faible, d'un ou plusieurs paramètres de dépôt a un fort impact sur la croissance des îlots et le risque de formation de dômes plastiquement relaxés (décrits ci-dessus) devient élevé. En raison de leur grande taille et des dislocations qu'ils contiennent, ces dômes relaxés détériorent les propriétés optiques des couches d'îlots. Comme décrit par Le Thanh et al. dans J. Vac. Sci. Technol. B, 20/3, pages 1259 à 1265, 2002, la croissance d'une couche d'îlots sur une couche d'îlots enterrée, c'est-à-dire une couche d'îlots recouverte par du silicium, est modifiée par les contraintes générées dans le silicium encapsulant par le plan d'îlots inférieur. Bensahel et al., dans le brevet US N° 6 596 555, ont proposé une séquence pour la formation d'un plan simple d'îlots, basée sur la génération d'un plus grand nombre de sites de formation des îlots grâce à un fort débit de germane en début de dépôt. Ils proposent de former des empilements en recouvrant cette couche d'îlots par du silicium et en répétant cette séquence autant de fois que nécessaire. Toutefois, ce procédé requiert des temps d'injection très courts.

### EXPOSÉ DE L'INVENTION

La présente invention propose une alternative au brevet US 6 596 555 en utilisant des paramètres de dépôt plus facilement contrôlables et reproductibles.

Il est proposé, selon la présente invention, un procédé permettant la réalisation d'empilements (de 1 à n périodes) de plans d'îlots d'un premier matériau semiconducteur (par exemple du germanium) encapsulés par un deuxième matériau semiconducteur (par exemple du silicium), ces îlots étant non relaxés plastiquement, de petite taille, avec une densité surfacique élevée, et réalisés à la température de croissance optimale pour les propriétés optiques (par exemple à 650 °C dans le cas d'îlots de germanium). Pour cela, on réalise un premier plan d'îlots encapsulé (par exemple par du silicium) dans des conditions de croissance permettant d'obtenir de fortes densités d'îlots de faible taille. Ce plan sera appelé « plan sacrificiel » car il peut être réalisé dans des conditions de croissance (pression et/ou température) ne permettant pas nécessairement d'obtenir de bonnes propriétés optiques.

Ensuite, grâce à l'utilisation des contraintes générées dans la couche de matériau semiconducteur encapsulante, le plan sacrificiel va permettre de générer de nombreux sites de nucléation pour les plans d'îlots suivants. Ces plans d'îlots suivants seront eux réalisés dans des conditions de croissance conduisant à de bonnes propriétés optiques.

L'invention a donc pour objet un procédé de réalisation d'une structure empilée de plans d'îlots d'un premier matériau semiconducteur encapsulés dans un deuxième matériau semiconducteur, sur un substrat, comprenant le dépôt alterné de plans d'îlots de premier matériau semiconducteur et de couches d'encapsulation de deuxième matériau semiconducteur, les plans d'îlots de premier matériau semiconducteur étant réalisés à une température de croissance optimale et sous une pression partielle de gaz précurseur optimale pour obtenir une structure empilée dont les propriétés optiques permettent une utilisation comme interconnexions optiques au sein de circuits intégrés, le procédé étant caractérisé en ce que la structure empilée est réalisée sur un plan d'îlots de troisième matériau semiconducteur, dit plan sacrificiel, encapsulé dans un quatrième matériau semiconducteur, les îlots du plan sacrificiel étant réalisés dans des conditions de croissance permettant d'obtenir de fortes densités d'îlots de faible taille, c'est-à-dire à une température inférieure à la température optimale de croissance et/ou sous une pression partielle de gaz précurseur supérieure à la pression partielle optimale.

Le premier matériau semiconducteur et le troisième matériau semiconducteur peuvent être identiques. Le deuxième matériau semiconducteur et le quatrième matériau semiconducteur peuvent aussi être identiques.

Avantageusement, le premier matériau semiconducteur est du germanium et le deuxième matériau semiconducteur est du silicium. Dans ce cas, les îlots de germanium peuvent être déposés à une température de l'ordre de 650°C et sous une pression partielle de germane de l'ordre de 0.11 Pa (0,83 mTorr).

Avantageusement aussi, le troisième matériau semiconducteur est du germanium et le quatrième matériau semiconducteur est du silicium. Dans ce cas, les îlots de germanium du plan sacrificiel peuvent être déposés à une température de l'ordre de 650°C et sous une pression partielle de germane de l'ordre de 0.88 Pa (6,56 mTorr). Ils peuvent aussi être déposés à une température de l'ordre de 550°C et sous une pression partielle de germane de l'ordre de 0.11 Pa (0,83 mTorr).

### BRÈVE DESCRIPTION DES DESSINS

L'invention sera mieux comprise et d'autres avantages et particularités apparaîtront à la lecture de la description qui va suivre, données à titre d'exemple non limitatif, et accompagnée des dessins annexés parmi lesquels :
- la figure 1 regroupe des diagrammes représentant la taille d'îlots de germanium en fonction de la pression partielle de germane,
- la figure 2 est un diagramme représentant la densités d'îlots de germanium en fonction de la pression partielle de germane,
- la figure 3 reproduit un cliché AFM d'une surface d'îlots de germanium réalisés à la température de croissance optimale et avec une pression partielle de germane standard de 0.11 Pa (0,83 mTorr),
- la figure 4 reproduit un cliché AFM d'une surface d'îlots de germanium réalisés à la température de croissance optimale et avec une pression partielle de germane élevée,
- la figure 5 reproduit un cliché AFM de la surface d'un empilement de deux plans d'îlots de germanium réalisé selon un procédé de l'art connu, et
- la figure 6 reproduit un cliché AFM de la surface d'un empilement de deux plans d'îlots de germanium réalisé selon le procédé de la présente invention.

### EXPOSÉ DÉTAILLÉ DE MODES DE RÉALISATION PARTICULIERS

On va maintenant décrire plus en détail la réalisation d'un empilement de plans d'îlots de germanium encapsulés dans du silicium en vue d'obtenir une structure possédant de bonnes propriétés optiques.

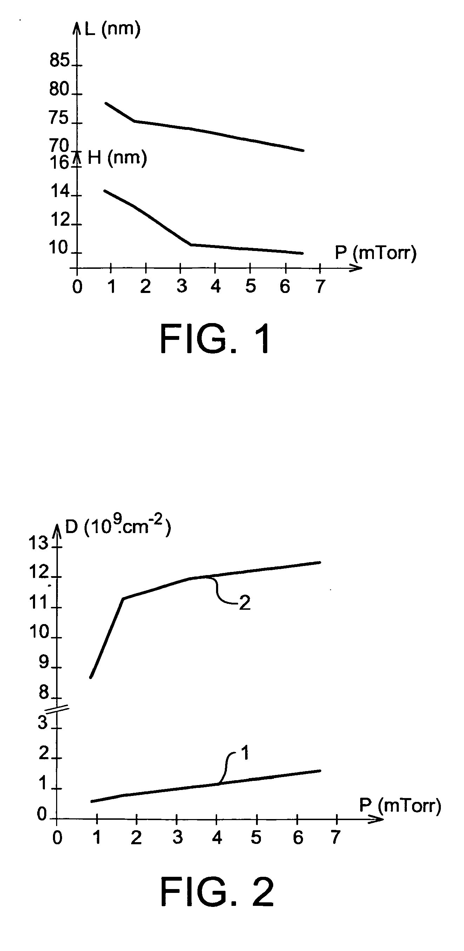

La figure 1 regroupe des diagrammes représentant la taille d'îlots de germanium (la largeur L et la hauteur H en nanomètres) en fonction de la pression partielle de germane (en mTorr) 1 Torr=1.33 hPa. La figure 2 est un diagramme représentant la densité de ces îlots de germanium en fonction de la pression partielle de germane. Sur le diagramme de la figure 2, la courbe 1 se rapporte aux pyramides obtenues et la courbe 2 se rapporte aux dômes obtenus.

Ces îlots ont été obtenus à la température constante de 650°C sur une face d'un substrat en silicium. On constate que plus la pression de germane est élevée, plus la densité surfacique est grande et plus la taille des îlots obtenus est faible.

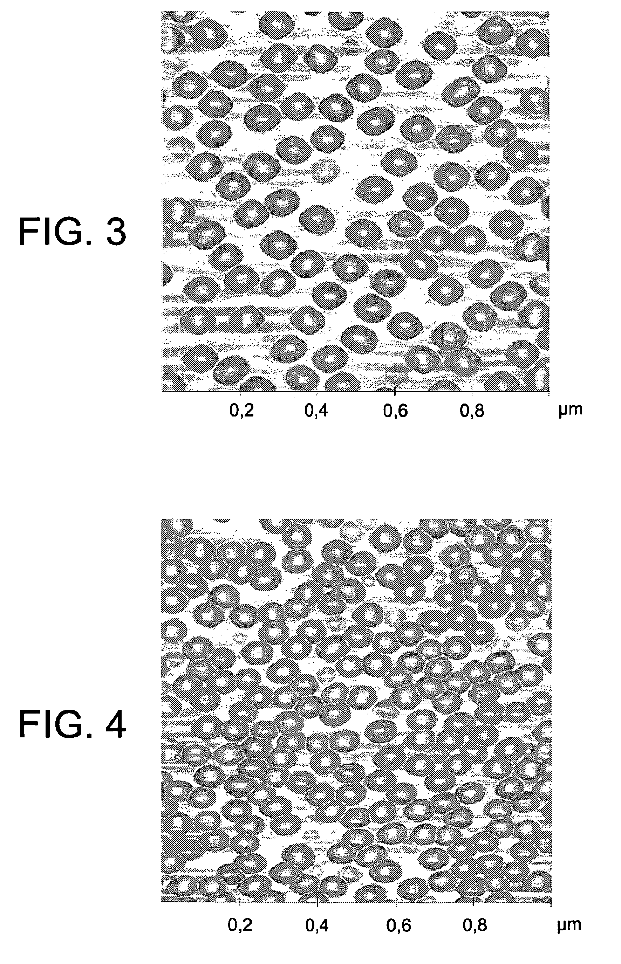

La figure 3 reproduit un cliché AFM (obtenu par un microscope à force atomique) d'une surface d'îlots de germanium réalisés sur une face d'un substrat en silicium à la température de croissance optimale (650°C) et avec une pression partielle de germane standard de 0.11 Pa (0,83 mTorr). La densité d'îlots obtenue est inférieure à 10¹⁰/cm².

La figure 4 reproduit un cliché AFM d'une surface d'îlots de germanium réalisés sur une face d'un substrat en silicium à la température de croissance optimale (650°C) et avec une pression partielle de germane élevée (0.88 Pa (6,56 mTorr)). On constate aisément, en comparant ces deux clichés, que la densité des îlots montrés sur le cliché de la figure 4 est plus élevée (quelques 10¹⁰/cm²) que la densité des îlots montrés sur le cliché de la figure 3 . On constate également que la taille des îlots montrés sur le cliché de la figure 4 est plus faible que la taille des îlots montrés sur le cliché de la figure 3.

On a ensuite réalisé, sur une face d'un substrat en silicium, un empilement de plans d'îlots de germanium encapsulés dans du silicium par une première variante du procédé selon l'invention. On a aussi réalisé, sur une face d'un substrat en silicium, un empilement de plans d'îlots de germanium encapsulés dans du silicium par une deuxième variante du procédé selon l'invention.

Selon la première variante du procédé selon l'invention, on réalise d'abord un plan sacrificiel à une température de 650°C et sous une pression partielle de germane de 0.88 Pa (6,56 mTorr). Les plans suivants sont réalisés à 650°C (température de croissance optimale) et sous une pression partielle de germane de 0.11 Pa (0,83 mTorr) (pression standard).

Selon la deuxième variante du procédé selon l'invention, on réalise d'abord un plan sacrificiel à une température de 550°C et sous une pression partielle de germane de 0.11 Pa (0,83 mTorr) (pression standard). Les plans suivants sont réalisés à 650°C (température de croissance optimale) et sous une pression partielle de germane de 0.11 Pa (0,83 mTorr) (pression standard).

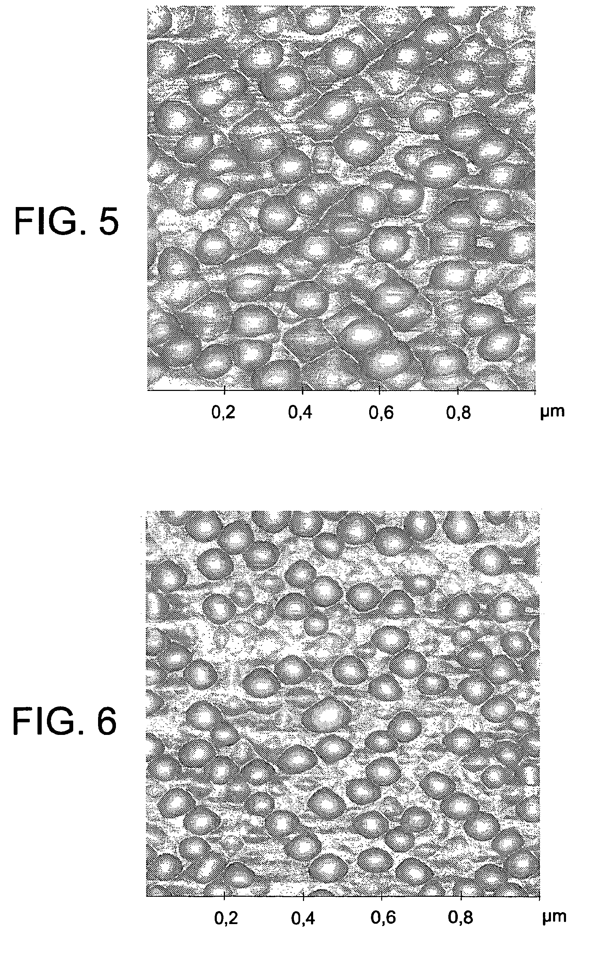

La figure 5 reproduit un cliché AFM de la surface d'un empilement de deux plans d'îlots de germanium encapsulés dans du silicium et réalisé, sur une face d'un substrat en silicium, selon un procédé de l'art connu. La température de dépôt pour ces deux plans est de 650°C et la pression partielle de germane pour ces deux plans est de 0.11 Pa (0,83 mTorr). Les structures de forme carrée observées sur le cliché AFM sont formées lors de l'encapsulation du premier plan d'îlots. La densité surfacique d'îlots pour le deuxième plan est inférieure à 5.10⁹ cm⁻². Elle est réduite d'un facteur deux par rapport au premier plan.

La figure 6 reproduit un cliché AFM de la surface d'un empilement de deux plans d'îlots de germanium encapsulés dans du silicium et réalisé, sur une face d'un substrat en silicium, selon le procédé de la présente invention. La température de dépôt du plan sacrificiel est de 650°C et la pression partielle de germane est de 0.88 Pa (6,56 mTorr). La température de dépôt du plan suivant est de 650°C et la pression partielle de germane est de 0.11 Pa (0,83 mTorr). La densité surfacique d'îlots pour le deuxième plan est alors deux fois plus élevée que pour le deuxième plan de l'exemple précédent (selon l'art connu) et les îlots sont aussi de plus petite taille.

La description précédente à été faite pour des îlots de germanium encapsulés dans du silicium, cependant l'invention s'applique également à d'autres matériaux semiconducteurs. Il est possible par exemple de réaliser un plan sacrificiel d'îlots de SiₓGe₁₋ₓ et de réaliser sur ce plan sacrificiel des empilements d'îlots de germanium.

L'invention s'applique également à tout procédé d'hétéroépitaxie permettant de réaliser des empilements d'îlots de matériaux semiconducteurs (IV-IV, III-V, etc.).

## Revendications

1. Procédé de réalisation d'une structure empilée de plans d'îlots d'un premier matériau semiconducteur encapsulés dans un deuxième matériau semiconducteur, sur un substrat, comprenant le dépôt alterné de plans d'îlots de premier matériau semiconducteur et de couches d'encapsulation de deuxième matériau semiconducteur, les plans d'îlots de premier matériau semiconducteur étant réalisés à une température de croissance optimale et sous une pression partielle de gaz précurseur optimale pour obtenir une structure empilée dont les propriétés optiques permettent la réalisation de composants optoélectroniques pour interconnecter des circuits intégrés, le procédé étant **caractérisé en ce que** la structure empilée est réalisée sur un plan d'îlots de troisième matériau semiconducteur, dit plan sacrificiel, encapsulé dans un quatrième matériau semiconducteur, les îlots du plan sacrificiel étant réalisés dans des conditions de croissance permettant d'obtenir de fortes densités d'îlots de faible taille, c'est-à-dire à une température inférieure à la température optimale de croissance et/ou sous une pression partielle de gaz précurseur supérieure à la pression partielle optimale.

2. Procédé selon la revendication 1, **caractérisé en ce que** le premier matériau semiconducteur et le troisième matériau semiconducteur sont identiques.

3. Procédé selon l'une des revendications 1 ou 2, **caractérisé en ce que** le deuxième matériau semiconducteur et le quatrième matériau semiconducteur sont identiques.

4. Procédé selon l'une quelconque des revendications 1 à 3, **caractérisé en ce que** le premier matériau semiconducteur est du germanium et le deuxième matériau semiconducteur est du silicium.

5. Procédé selon la revendication 4, **caractérisé en que** les îlots de germanium sont déposés à une température de l'ordre de 650°C et sous une pression partielle de germane de l'ordre de 0.11 Pa.

6. Procédé selon l'une quelconque des revendications 1 à 5, **caractérisé en ce que** le troisième matériau semiconducteur est du germanium et le quatrième matériau semiconducteur est du silicium.

7. Procédé selon la revendication 6, **caractérisé en ce que** les îlots de germanium du plan sacrificiel sont déposés à une température de l'ordre de 650°C et sous une pression partielle de germane de l'ordre de 0.88 Pa.

8. Procédé selon la revendication 6, **caractérisé en ce que** les îlots de germanium du plan sacrificiel sont déposés à une température de l'ordre de 550°C et sous une pression partielle de germane de l'ordre de 0.11 Pa.

## Claims

1. Process for making a stacked structure of planes of islands of a first semiconducting material encapsulated in a second semiconducting material on a substrate, comprising alternate deposition of planes of islands of a first semiconducting material and encapsulation layers of a second semiconducting material, the planes of islands of the first semiconducting material being made at an optimum growth temperature and at an optimum precursor gas partial pressure to result in a stacked structure for which the optical properties enable production of optoelectronic components to interconnect integrated circuits, the process being **characterised in that** the stacked structure is made on a plane of islands of a third semiconducting material called the sacrificial plane encapsulated in a fourth semiconducting material, the islands of the sacrificial plane being made under growth conditions that can result in high densities of small islands, in other words at a temperature below the optimum growth temperature and / or at a precursor gas partial pressure greater than the optimum partial pressure.

2. Process according to claim 1, **characterised in that** the first semiconducting material and the third semiconducting material are identical.

3. Process according to either claim 1 or 2, **characterised in that** the second semiconducting material and the fourth semiconducting material are identical.

4. Process according to any one of claims 1 to 3, **characterised in that** the first semiconducting material is germanium and the second semiconducting material is silicon.

5. Process according to claim 4, **characterised in that** the germanium islands are deposited at a temperature of the order of 650°C and at a germane partial pressure of the order of 0.11 Pa.

6. Process according to any one of claims 1 to 5, **characterised in that** the third semiconducting material is germanium and the fourth semiconducting material is silicon.

7. Process according to claim 6, **characterised in that** the germanium islands in the sacrificial plane are deposited at a temperature of the order of 650°C and at a germane partial pressure of the order of 0.88 Pa.

8. Process according to claim 6, **characterised in that** the germanium islands in the sacrificial plane are deposited at a temperature of the order of 550°C and at a germane partial pressure of the order of 0.11 Pa.

## Patentansprüche

1. Verfahren zur Herstellung einer Schichtstapel-Struktur von Ebenen von Inseln aus einem ersten Halbleitermaterial, die in einem zweiten Halbleitermaterial gekapselt sind, auf einem Substrat, das Verfahren umfassend das alternierende Abscheiden von Ebenen von Inseln aus erstem Halbleitermaterial und von Kapselungsschichten aus zweitem Halbleitermaterial, wobei die Ebenen von Inseln aus erstem Halbleitermaterial bei einer Temperatur optimalen Wachstums und bei einem optimalen Partialdruck eines Vorläufergases erzeugt werden zur Erzielungs einer Stapelstruktur, deren optische Eigenschaften die Schaffung von opto-elektronischen Bauteilen zur Verbindung integrierter Schaltungen gestatten, das Verfahren **dadurch gekennzeichnet, dass** die Stapelstruktur auf einer Ebene von Inseln aus einem dritten Halbleitermaterial erzeugt wird, die als opferbare oder verlorene Ebene bezeichnet wird und in einem vierten Halbleitermaterial gekapselt ist, wobei die Inseln der opferbaren Ebene unter Wachstumsbedingungen erzeugt werden, welche die Erzielung hoher Dichten von Inseln kleiner Abmessungen gestatten, das heißt bei einer Temperatur, die niedriger als die optimale Wachstumstemperatur ist und /oder unter einem Partialdruck des Vorläufergases, der über dem optimalen Partialdruck liegt.

2. Verfahrren nach Anspruch 1, **dadurch gekennzeichnet, dass** das erste Halbleitermaterial und das dritte Halbleitermaterial gleich sind.

3. Verfahren nach einem der Ansprüche 1 oder 2, **dadurch gekennzeichnet, dass** das zweite Halbleitermaterial und das vierte Halbleitermaterial gleich sind.

4. Verfahren nach einem der Ansprüche 1 bis 3, **dadurch gekennzeichnet, dass** das erste Halbleitermaterial Germanium und das zweite Halbleitermaterial Silizium ist.

5. Verfahren nach Anspruch 4, **dadurch gekennzeichnet, dass** die Inseln aus Germanium bei einer Temperatur in der Größenordnung von 650 ° C und unter einem Partialdruck von German der Größenordnung von 0,11 Pa (0,83 mTorr) abgeschieden werden.

6. Verfahren nach einem der Ansprüche 1 bis 5, **dadurch gekennzeichnet, dass** das dritte Halbleitermaterial Germanium und das vierte Halbleitermaterial Silizium ist.

7. Verfahren nach Anspruch 6, **dadurch gekennzeichnet, daß** die Germanium-Inseln der opferbaren oder verlorenen Ebene bei einer Temperatur in der Größenordnung von 650 °C und bei einem Partialdruck des German in der Größenordnung von 0,88 Pa (6,56 mTorr) abgeschieden werden.

8. Verfahren nach Anspruch 6 , **dadurch gekennzeichnet, daß** die Germanium-Inseln der opferbaren bzw. verlorenen Ebene bei einer Temperatur in der Größenordnung von 550 ° C und bei einem Partialdruck des German in der Größenordnung von 0,11 Pa (0,83 mTorr) abgeschieden werden.
